**Europäisches Patentamt**

**European Patent Office**

**Office européen des brevets**

(19)

(11) Veröffentlichungsnummer: **0 061 622**
**B1**

(12) **EUROPÄISCHE PATENTSCHRIFT**

(45) Veröffentlichungstag der Patentschrift:
**13.02.85**

(51) Int. Cl.⁴: **H 03 J 1/06,** E 05 D 11/10,
H 04 N 5/64, H 04 B 1/08

(21) Anmeldenummer: **82101996.5**

(22) Anmeldetag: **12.03.82**

(54) **Drucktastenaggregat.**

(30) Priorität: **31.03.81 DE 3112753**

(43) Veröffentlichungstag der Anmeldung:
**06.10.82 Patentblatt 82/40**

(45) Bekanntmachung des Hinweises auf die Patenterteilung:
**13.02.85 Patentblatt 85/7**

(84) Benannte Vertragsstaaten:
**FR GB IT**

(56) Entgegenhaltungen:
**DE - A - 1 779 273**
**DE - A - 1 911 898**
**DE - A - 2 163 689**
**DE - A - 2 833 184**
**FR - A - 2 458 243**
**GB - A - 1 551 827**
**US - A - 3 600 743**

(73) Patentinhaber: **PREH, Elektrofeinmechanische Werke Jakob Preh Nachf. GmbH & Co.,**
**Postfach 1740 Schweinfurter Strasse 5, D-8740 Bad Neustadt/Saale (DE)**

(72) Erfinder: **Bauer, Karl-Heinz, Lerchenstrasse 9,**
**D-8740 Bad Neustadt/Saale (DE)**
Erfinder: **Maisch, Edgar, Frühlingstrasse 13 1/2,**
**D-8740 Bad Neustadt/Saale (DE)**
Erfinder: **Wolf, Reinhold, Hangweg 17, D-8740 Bad Neustadt/Saale (DE)**

## Beschreibung

Die Erfindung geht von einem Drucktastenaggregat nach dem Oberbegriff des Anspruches 1 aus.

Derartige Drucktastenaggregate werden in verschiedenen Ausführungsformen bevorzugt bei der Abstimmung und Einschaltung von HF-Empfängern, wie z. B. Fernsehempfängern, eingesetzt. Durch einen einzigen Tastendruck kann jeweils die voreingestellte Abstimmspannung und damit die zugeordnete Station bzw. der Kanal eingeschaltet werden. Die Speicherung der eingestellten Abstimmspannung erfolgt in Kanalspeichern in der Form von als Spannungsteiler geschalteten Spindelwiderständen oder Drehwiderständen. Die Kanalspeicher und deren Anzeigemittel sowie eventuell zur Frequenzbereichsvorwahl vorgesehene Einstellorgane brauchen und sollen im Normalbetrieb des Gerätes nicht unmittelbar zugänglich sein, da sie leicht zu einer unwissentlichen oder unbeabsichtigten Fehlbedienung des Gerätes führen können. Außerdem kann bei zunehmender Zahl der Druckdrehknöpfe das Aussehen des Gerätes ungünstig beeinflußt werden. Man ist daher dazu übergegangen, die Einstellorgane in Vertiefungen des Gehäuses unterzubringen und diese Vertiefungen durch Abdeckungen in der Form von Klapptüren zu verschließen. Es besteht ferner der Trend, möglichst viele Druckdrehknöpfe zur Verfügung zu haben. Andererseits ist der auf der Frontseite der Fernsehempfänger vorhandene Platz meist sehr beschränkt. Dies bedeutet letztlich, daß der Abstand der Druckdrehknöpfe immer kleiner wird. Der seitliche Abstand kann aber ein bestimmtes Maß nicht unterschreiten, da die im gedrückten Zustand tief liegenden Einstellorgane, die ja gleichzeitig auch zur Abstimmung dienen, noch bequem mit den Fingern gedreht werden sollen. Um den seitlichen Abstand trotzdem noch verringern zu können, hat man den Einsatz eines Hilfsmittels in der Form eines Steckschlüssels vorgesehen.

Es ist bereits bekannt (DE-Zeitschrift Funkschau 1968, Heft 10, S. 306), das Drucktastenaggregat in Form eines Einschubes auszubilden, auf dessen auch in eingeschobenem Zustand zugänglichen Stirnseite die Drucktasten für die Schalter angebracht sind, während die Abstimmhandhaben für die Spannungsteiler und für die Bereichswahlorgane erst nach Herausziehen des Aggregates aus dem Gerät bedient werden können. Eine derartige Anordnung ist jedoch wegen der im Gerät erforderlichen Führungen für den Einschub und wegen seiner beweglichen Zuleitungen recht aufwendig und mit Unsicherheitsfaktoren behaftet.

Es ist ferner bereits aus der DE-B-1 591 713 ein Drucktastenaggregat bekannt, bei dem jeder Kanalspeicher in einer Tasche bzw. in einer etwas vertieften Aussparung untergebracht ist und wobei jeder Kanalspeicher mit einem in Form einer großen Drucktaste ausgebildeten Deckel versehen ist. Dieser Deckel ist federnd rückstellend, dreh- und aufklappbar und er liegt so auf dem Einschaltorgan auf, daß dieses durch Druck auf den geschlossenen Deckel betätigt werden kann. Da das Einschaltorgan neben seiner Schaltfunktion auch noch zur Abstimmung dient, müssen die Einschaltorgane einen relativ großen gegenseitigen seitlichen Abstand besitzen, damit die im gedrückten Zustand tief liegenden Einschaltorgane, die ja gleichzeitig auch zur Abstimmung dienen, noch bequem mit dem Finger gedreht werden können.

Eine geringere Einbaubreite benötigt bei gleicher Anzahl der Druckdrehknöpfe ein weiteres bekanntes Drucktastenaggregat (DE-B-1 911 898) der eingangs genannten Art, bei dem die Druckdrehknöpfe zur Kanaleinschaltung mittels einzelner Tasten betätigbar sind, die in einer allen Druckdrehknöpfen gemeinsamen Klapptür schwenkbar gelagert sind. Die Frequenzbereichswahl kann nur bei geöffneter Klapptür vorgenommen werden. Im Rahmen der aus Kunststoff hergestellten Klapptür ist an einer der Längsseiten eine Metallschiene befestigt, deren endseitige Lagerzapfen mit je einer Metallhalterung zusammenwirken, die ihrerseits im Gehäuse des Drucktastenaggregates befestigt sind. Dieser konstruktive Mehraufwand soll verhindern, daß die Klapptür an ihren Scharnieren ausbricht. In der Seitenwand des Gehäuses sind unterhalb von Lagerdurchbrüchen in der Klapptür Blattfederzungen aus Metall befestigt, die mit ihren freien Zungenenden in die Lagerdurchbrüche hineinragen. Bei geschlossener Klapptür liegen die Zungenenden auf der Innenseite der Tasten unter Vorspannung an. Die Blattfederzungen üben auf die Tasten und auch auf die Klapptür ein Drehmoment im Uhrzeigersinn aus, so daß die Tasten mit leichtem Druck auf den Druckdrehknöpfen aufliegen und die Klapptür auf das Gehäuse gedrückt wird. Zur Veränderung der Kanalabstimmung wird die Klapptür entgegen dem Uhrzeigersinn geschwenkt. Die Zungenenden legen sich dann mit Vorspannung an abgeschrägte Flächen der Klapptür an, so daß die Klapptür mit einer leichten Rastkraft in dieser Stellung gehalten wird.

Aufgabe der vorliegenden Erfindung ist es, für ein Drucktastenaggregat nach der eingangs genannten Art eine Drehverbindung für die Klapptür zu finden, die einfach und kostensparend herzustellen ist und die insbesondere für eine Klapptür mit einer geringen Breite geeignet ist.

Diese Aufgabe wird erfindungsgemäß durch die im kennzeichnenden Teil des Patentanspruches 1 angegebenen Merkmale gelöst.

Weitere vorteilhafte Ausgestaltungen der Erfindung sind den Unteransprüchen zu entnehmen.

Die Verwendung einer Klapptür mit einer geringen Breite erlaubt es, die Vertiefung lang und schmal auszuführen. Dies kommt dem Bestreben entgegen, Drucktastenaggregate möglichst mit geringem Platzbedarf auf der Frontseite der Geräte durch einen räumlich gedrängten Aufbau ohne Verlust der leichten Bedienbarkeit zu konstruieren. Es ist auch leicht möglich, nebeneinander in zwei Vertiefungen liegende Reihen von Drehknöpfen mit nur einer Klapptür abdecken zu können.

Einzelheiten der Erfindung werden nachfolgend für ein Beispiel anhand der Zeichnungen näher erläutert. Von den Figuren zeigt

Fig. 1 eine perspektivische Ansicht eines Drucktastenaggregates,

Fig. 2 die Rückansicht einer Klapptür,

Fig. 3 die Rückansicht einer anderen Klapptür,

Fig. 4 im vergrößerten Maßstab eine Seitenansicht der Klapptür teilweise im Schnitt,

Fig. 5 im vergrößerten Maßstab das Federelement der Klapptür im Schnitt,

Fig. 6 im vergrößerten Maßstab das Federelement der Klapptür in der Draufsicht,

Fig. 7 im vergrößerten Maßstab die Drehverbindung Klapptür/Gehäuse bei geschlossener Klapptür,

Fig. 8 im vergrößerten Maßstab die Drehverbindung Klapptür/Gehäuse bei offener Klapptür und

Fig. 9 eine perspektivische Ansicht eines Drucktastenaggregates mit zwei Drucktastenreihen.

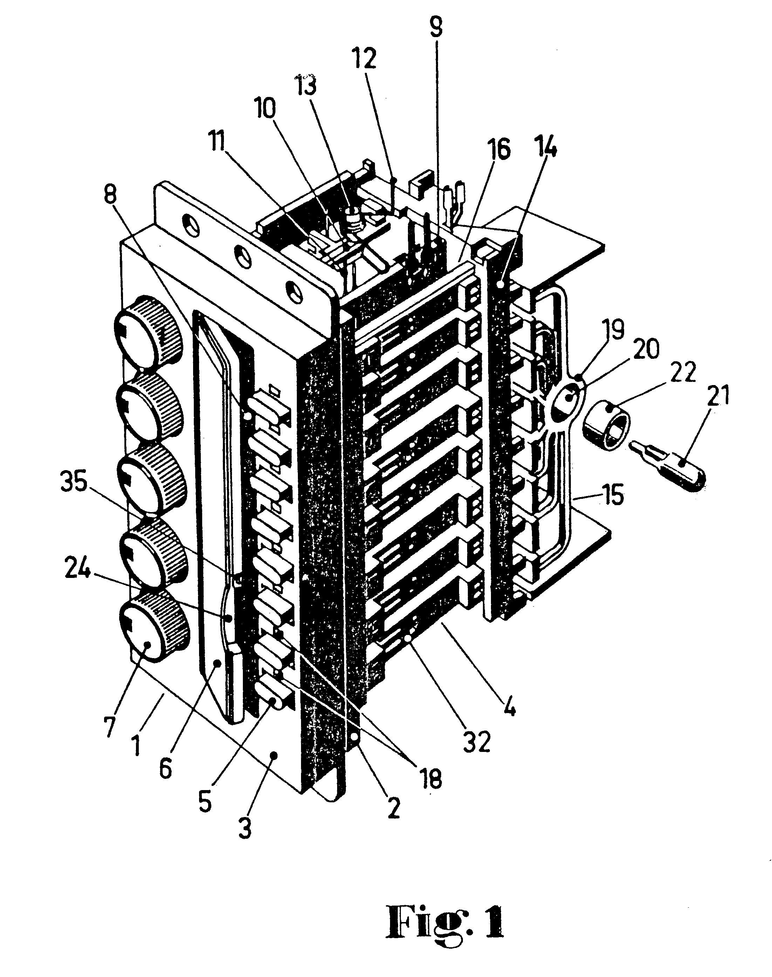

Das in Fig. 1 in perspektivischer Ansicht dargestellte und mit 1 bezeichnete Drucktastenaggregat besitzt eine Reihe von acht mittels einer Sperrschiene gegenseitig auslösbaren Drucktasten 4 zur Einschaltung der in den einzelnen Kanalspeichern voreingestellten Abstimmspannungen. Selbstverständlich ist auch eine hiervon abweichende Anzahl von Drucktasten denkbar. Das Drucktastenaggregat 1 besteht im wesentlichen aus einem Speichergehäuse 2 und einer Gehäusefrontseite 3 mit Einstell-, Schalt- und Anzeigeorganen.

Bei dem in Fig. 1 dargestellten Ausführungsbeispiel bestehen die einzelnen Einstellorgane für die Lautstärke, Bildhelligkeit, Kontrast usw. aus mehreren Drehwiderständen mit ihren zugeordneten Drehknöpfen 7, die seitlich zu der Drucktastenreihe angeordnet sind. Anstelle der Drehwiderstände können auch Schiebewiderstände Verwendung finden. Es ist hierbei selbstverständlich, daß die Anordnung der Einstellorgane, seien es nun Schiebe- oder Drehwiderstände, auch ober- oder unterhalb der Drucktastenreihe möglich ist.

Da die nicht sichtbaren Druckdrehknöpfe für die Einstellung der Abstimmspannungen im Normalbetrieb des Gerätes nicht unmittelbar zugänglich sein sollen, befinden sich diese in einer Vertiefung 8 der Gehäusefrontseite 3. Diese Vertiefung 8 ist durch eine Abdeckung verdeckt. Hierdurch soll eine unwissentliche oder unbeabsichtigte Fehlbedienung des Gerätes vermieden werden. Die Abdeckung ist eine Klapptür 6.

Hinter der Gehäusefrontseite 3 ist das Speichergehäuse 2 angeordnet. In diesem befinden sich Spindelwiderstände, die die Kanalspeicher darstellen. Diese bestehen jeweils aus einer Spindel, auf der ein Federträger entlanggeführt ist, auf dem eine Schleiffeder befestigt ist, die zwischen Widerstand und Spindel eine elektrische Verbindung herstellt. Durch die Stellung des Federträgers wird die Abstimmspannung eingestellt. Die einzelnen Widerstände sind nebeneinander auf einer Isolierstoffplatte 9 aufgebracht, die im Speichergehäuse gehaltert ist. An einem Ende weist jede Spindel einen Druckdrehknopf auf, der in die Vertiefung der Gehäusefrontseite ragt und der mit einer geriffelten oder sonstwie griffig gestalteten Randung — falls Handbedienung ohne Hilfsmittel erfolgt — versehen ist. Der Druckdrehknopf besitzt außerdem eine Höhlung, die ein bestimmtes Innenprofil aufweist. Zur Abstimmung wird ein Steckschlüssel 10 in diese Höhlung gesteckt, der gleichzeitig der Schaltstößel für einen AFC-Schalter ist. Mit dem Schaltstößel können außerdem auch die Schaltorgane für die Frequenzbereichswahl betätigt werden. Hierzu muß der Druckdrehknopf lediglich gedrückt und anschließend in eine der Schaltpositionen gedreht werden.

Der AFC-Schalter besteht aus einem ersten ortsfesten Kontaktstück 11, das aus Draht hergestellt ist. Ebenfalls aus Draht hergestellt ist das zweite Kontaktstück 12. Dieses zweite Kontaktstück ist zweiarmig ausgebildet, wobei ein Arm von dem schwenkbaren Kontaktelement gebildet wird. Dieses Kontaktelement dient neben der Kontaktierung noch dazu, den Steckschlüssel 10 beim Öffnen der Klapptür 6 aus dem Gehäuse soweit herauszudrücken, daß er bequem mit dem Finger ganz herausgezogen werden kann. Der andere Arm wird durch ein ortsfestes Anschlußstück gebildet. Beide Arme sind durch ösenförmige Windungen miteinander verbunden, die um einen angeformten Zapfen 13 liegen, der eine Art Widerlager für das zweite Kontaktstück darstellt. Darüberhinaus stützt sich das ortsfeste Anschlußstück noch in einem Schlitz einer angeformten Halterung ab. Immer dann, wenn die Abstimmspannung mit Hilfe des Steckschlüssels neu eingestellt wird, wird durch die Herausnahme des Steckschlüssels aus dem Drucktastenaggregat der AFC-Schalter ausgeschaltet. Ist die Klapptür 6 jedoch geschlossen, so ist der AFC-Schalter eingeschaltet, so daß eine automatische Frequenzregelung wirksam werden kann.

Zur Kanaleinschaltung dienen die Drucktasten 4, wobei ein Ende in der hinteren Längswand 14 des Speichergehäuses 2 in einer Führung geführt ist. Das andere Ende, das in der vorderen Längswand geführt ist, trägt an seiner aus dem Speichergehäuse herausragenden Stirnseite den Betätigungsknopf 5, der im Preßsitz auf die Drucktaste aufgedrückt ist oder der direkt an die Drucktaste einstückig angespritzt ist. Durch eine Haltenase und durch einen Anschlag ist jede Drucktaste in dem Speichergehäuse gehaltert und in seiner Verschieberichtung begrenzt. Das in Fig. 1 dargestellte Drucktastenaggregat soll insbesondere in Fernsehempfängern eingesetzt werden. Hierzu ist es erforderlich, daß neben der Kanaleinschaltung noch die Frequenzbereichsumschaltung vorgenommen wird. Deshalb werden mit der Drucktaste zwei voneinander unabhängige Kontaktsysteme betätigt. Aus diesem Grunde auch sind in länglichen Aussparungen auf der Unterseite der Drucktaste zwei Blattfedern angeordnet. Jede Blattfeder ist J-förmig ausgebildet mit einem langen und einem kurzen Federarm, wobei beide über ein bogenförmiges Zwischenstück miteinander einstückig verbunden sind. Diese Blattfeder ist zwischen zwei Widerlager eingespannt und zwar so, daß sie einseitig leicht gewölbt ist. Man erreicht dies unter anderem dadurch, daß man die beiden Widerlager nichtfluchtend zueinander anordnet. Die Blattfeder erfüllt eine Doppelfunktion, da sie einerseits Kontaktfeder, andererseits aber auch Rückholfeder für die Drucktaste ist. Der lange Federarm übernimmt im wesentlichen die Funktion der Rückholfeder, während der kurze Federarm als Kontaktarm dient. Durch diese besondere J-förmige Ausgestaltung der Blattfeder ist die Drucktaste sehr leichtgängig. Da beim Drücken der Drucktaste hauptsächlich nur die Knickkraft des bereits vorgewölbten langen, relativ weichen Federarmes überwunden werden muß, zu dem noch die Anpreßkraft des kurzen Federarmes an ein ortsfestes Kontaktstück hinzukommt, wobei diese Anpreßkraft jedoch im Verhältnis der Abstände der Wirkungspunkte reduziert ist.

Um die Stellung der Drucktasten auch aus der Ferne besser erkennen zu können, ist das Drucktastenaggregat mit einer Leuchtanzeigeeinrichtung ausgestattet. Diese besteht aus mehreren Lichtleitern, die sternförmig von einem Leuchtzentrum aus zu den einzelnen Drucktasten hingeführt sind und deren Enden 18 in einer Öffnung der Gehäusefrontseite sichtbar sind. Das Leuchtzentrum selbst besteht aus einer Fassung 19 aus durchsichtigem Kunststoff, in derem Hohlraum 20 eine Lampe 21 eingesetzt ist. Die Lichtleiter sind aus einem durchsichtigen glasklaren Kunststoff hergestellt, so daß die sichtbaren Enden 18 bei gedrückter Drucktaste hell bzw. weiß erscheinen. Es besteht auch die Möglichkeit einer farbigen Anzeige. Grundsätzlich könnte ein eingefärbter Kunststoff verwendet werden. Einfacher jedoch ist es, einen speziellen Farbträger zu nehmen, der zwischen Lampe und Fassung im Hohlraum eingesetzt ist. Sollen alle Drucktasten die gleiche Farbanzeige aufweisen, so genügt es, einen ringförmigen Farbträger 22 zu nehmen, der einfarbig ausgeführt ist.

Die Leuchtanzeigeeinrichtung setzt sich aus zwei Teilen, einem ersten Teil 15 und einem zweiten Teil 16 zusammen. Der erste Teil besitzt in der Mitte das Leuchtzentrum mit der Fassung 19 und der Lampe 21. Von diesem Leuchtzentrum führen Lichtleiter weg, deren Anzahl der Anzahl der Drucktasten entspricht. Außerdem sind alle Lichtleiter durch einen ersten Haltesteg miteinander verbunden, der gleichzeitig auch der Befestigung des ersten Teiles an dem Speichergehäuse dient. Der zweite Teil der Leuchtanzeigeeinrichtung besteht im wesentlichen aus parallel geführten Lichtleitern, deren Enden 18 in den Öffnungen der Gehäusefrontseite sichtbar sind. Verbunden sind diese Lichtleiter durch einen zweiten Haltesteg. Zwischen dem ersten und dem zweiten Teil befindet sich eine Luftstrecke, in die der hintere Teil des flachen Tastenschiebers 32 ragt. Dieser hintere Teil besteht aus einer Blendenwand und einem Fenster. Befindet sich die Drucktaste in der Schaltstellung »AUS«, so ragt die Blendenwand in die Luftstrecke. Die Lichtführung ist somit unterbrochen. Ist die Drucktaste jedoch gedrückt, so ragt das Fenster in die Luftstrecke und das Licht kann ungehindert die Luftstrecke durchqueren, so daß das Ende 18 aufleuchtet.

Wie aus Fig. 1 hervorgeht, liegen alle Drucktasten in einer Reihe, so daß sich auch die Lichtleiter nur in einer Ebene befinden. Soll das Drucktastenaggregat jedoch zwei nebeneinanderliegende Reihen von Drucktasten aufweisen, so müssen die Lichtleiter auch in zwei Reihen angeordnet werden. Hierzu wird auf den ersten Teil 15 ein Zusatzteil aufgesteckt. Dieses besteht aus einem hülsenförmigen Basisteil, das auf die Fassung 19 aufgedrückt wird. Von dem Basisteil sind mehrere Lichtleiter über bogenförmige und gerade Teilstücke und über Abwinkelungen weggeführt. Die in der Fassung untergebrachte Lampe versorgt sowohl die Lichtleiter der ersten Ebene, als auch die in der zweiten Ebene liegenden Lichtleiter. Durch einen dritten Haltesteg ist das Zusatzteil im Gehäuse befestigt. So ist auf einfache Weise eine Erweiterungsmöglichkeit gegeben.

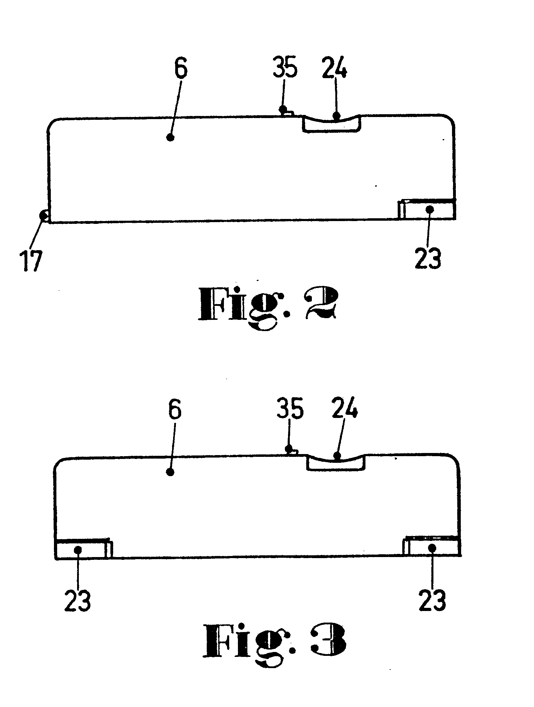

Wie aus Fig. 1 zu entnehmen ist, ist die Vertiefung 8 lang und schmal vorgesehen. Daran angepaßt ist die Klapptür 6 ebenfalls lang und schmal. Zwei Ausführungen einer Klapptür sind in den Fig. 2 und 3 dargestellt. Jede Klapptür besitzt an den beiden Schmalseiten Teile einer Drehverbindung, mit deren Hilfe die Klapptür im Gehäuse um eine Achse, in diesem Fall die Längsachse der Klapptür, in einem Winkelbereich schwenkbar ist.

Bei der ersten Ausführung einer Klapptür ist an die Klapptür 6, wie aus Fig. 2 ersichtlich ist, an einer der Schmalseiten ein Lagerzapfen 17 angeformt, der mit einer in Fig. 1 nicht sichtbaren Bohrung im Gehäuse als erstes Drehlager zusammenwirkt. Das zweite Drehlager wird unter anderem von einem gegenüberliegenden Federelement gebildet, das aus einem Federarm 23 besteht, der von der Klapptür teilweise freigeschnitten ist, so daß er federnd auslenkbar ist. Da die Klapptür lang und schmal ausgeführt ist, erstreckt sich der Federarm in drehaxialer Richtung. Es wäre natürlich auch möglich, den Federarm senkrecht, also parallel zur Schmalseite anzuordnen, dann könnte jedoch aus konstruktiven Gründen die Klapptür aufgabengemäß nicht so schmal ausgebildet werden. Die in Fig. 3 dargestellte zweite Ausführung der Klapptür besitzt an Stelle des Lagerzapfens 17 einen weiteren Federarm. Vergleicht man beide Ausführungsformen, so ist zweifelsohne die Klapptür gemäß Fig. 2 einfacher ausgebildet. Beide Ausführungsformen der Klapptür haben jedoch auf der Längsseite eine Ausnehmung 24 gemeinsam, in die der Finger einer Betätigungsperson eingreifen kann, um die Klapptür besser öffnen zu können.

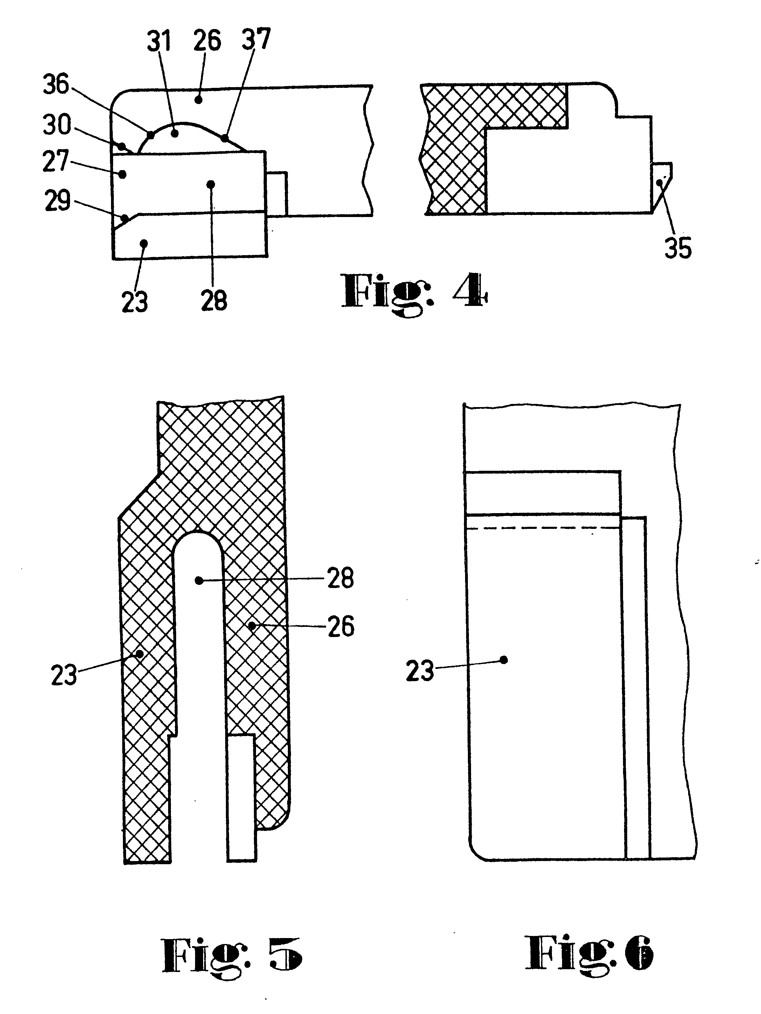

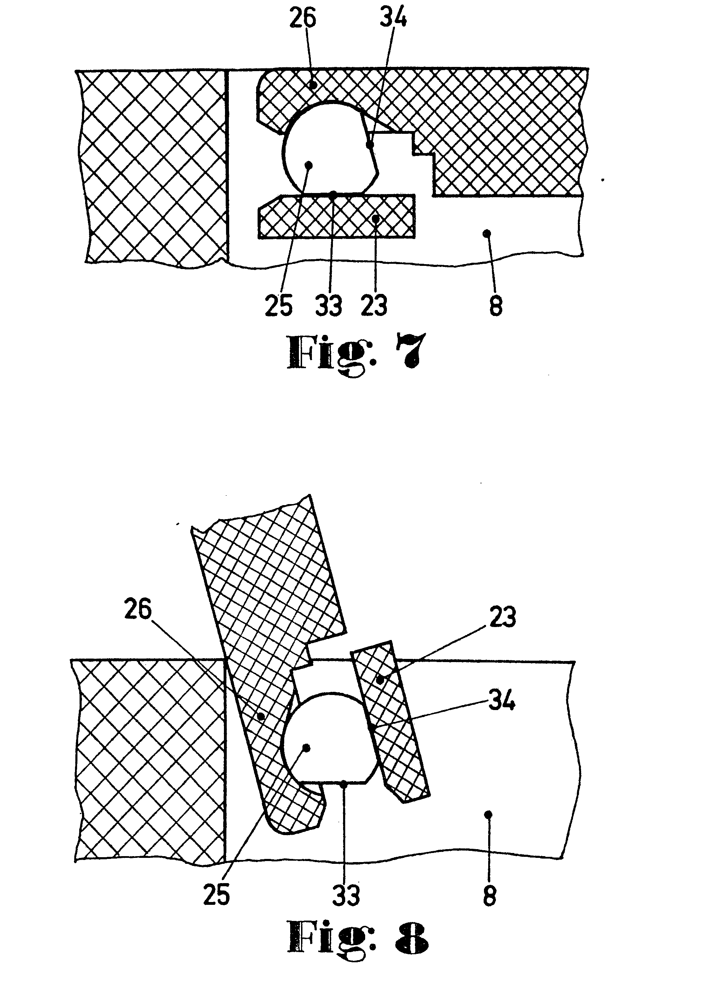

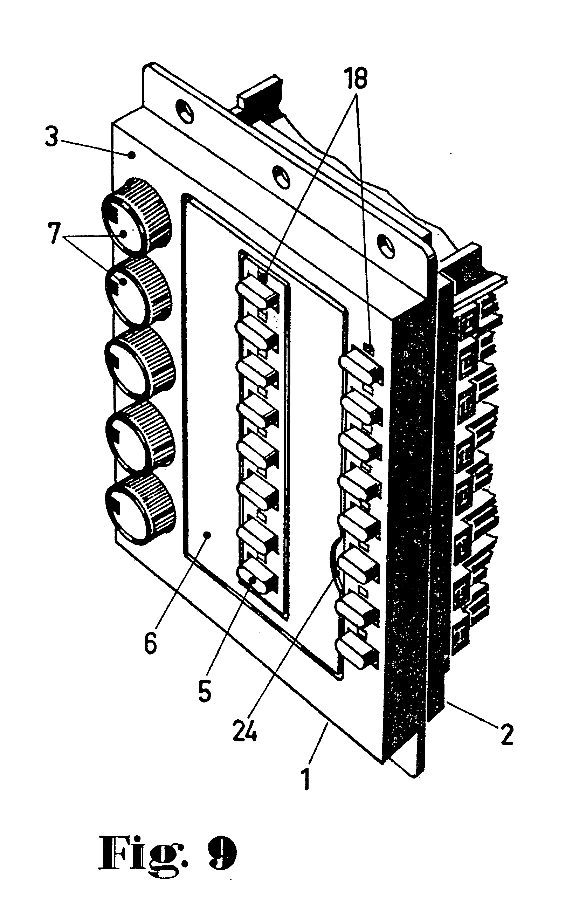

Einzelheiten der Drehverbindung, insbesondere des Federarmes 23 sind aus den Fig. 4 bis 8 zu entnehmen. Zwischen dem Federarm 23 und dem Basisteil 26 der Klapptür 6 befindet sich ein an das Gehäuse angeformter Drehzapfen 25. Um diesen Drehzapfen leichter in die Öffnung 28 zwischen Federarm und Basisteil der Klapptür einführen zu können, besitzt der Federarm 23 im Bereich der Einstecköffnung 27 eine Anschrägung 29. Eine weitere Anschrägung 30 ist zum gleichen Zweck am Basisteil 26 der Klapptür vorgesehen. An die Anschrägung 30 schließt sich im Basisteil eine Aussparung 31 an, die eine halbkreisförmige und eine von einem Halbkreis abweichende Profilierung besitzt. In dieser Aussparung befindet sich der Drehzapfen 25. Der Federarm hält den Drehzapfen in der Aussparung. Hierzu ist der Abstand Federarm – Basisteil ohne eingeschnappten Drehzapfen etwas kleiner als der Durchmesser des Drehzapfens. Der Federarm ist somit vorgespannt. Der Drehzapfen selbst ist rund bis auf zwei Abflachungen 33 und 34, die am Umfang unter einem Winkel zueinander liegen. Die Funktion der Abflachungen ist aus den Fig. 7 und 8 zu entnehmen. Die Fig. 7 zeigt die Klapptür in geschlossenem Zustand. Der Federarm 23 liegt an der Abflachung 33 an. In dieser Raststellung wird die Klapptür zusätzlich durch eine angeformte vorspringende Nase 35 im Gehäuse geschlossen gehalten. Greift man mit dem Finger in die Ausnehmung 24 und drückt die Klapptür leicht zur Seite, so geht die Klapptür auf und sie kann bis in die zweite Raststellung geschwenkt werden. In Fig. 8 ist diese Raststellung dargestellt. Jetzt liegt der Federarm 23 an der Abflachung 34 an. Mit der zweiten Raststellung wird erreicht, daß die Klapptür auch dann noch offen bleibt, wenn das Drucktastenaggregat um einen rechten Winkel gedreht und mit obenliegender Drehachse in ein Fernsehgerät eingebaut wird.

Die Profilierung der Aussparung besteht aus einem kreissegmentförmigen ersten Abschnitt 36 und einem sich daran tangential anschließenden zweiten Abschnitt 37. Dieser Abschnitt weist eine Schrägfläche auf, die im Sinne einer Verengung der Aussparung wirkt. In der ersten Raststellung liegt der runde Teil des Drehzapfens 25 in dem kreissegmentförmigen ersten Abschnitt 36. Wird die Klapptür nun zur Seite geschoben, um sie zu öffnen, so gleitet der Drehzapfen auf der Schrägfläche entlang. Der Federarm wird somit aufgebogen. Wird der Fingerdruck aufgehoben, so gleitet der Drehzapfen aufgrund der vom Federarm auf den Drehzapfen ausgeübten Kraft wieder in den ersten Abschnitt 36 zurück.

Wenngleich in Fig. 1 nur eine Drucktastenreihe dargestellt ist, so kann die Erfindung auch bei einer Mehrfachdrucktastenreihe Verwendung finden. Hierzu muß in der Klapptür lediglich ein Fenster für z. B. eine Drucktastenreihe vorgesehen werden. In Fig. 9 ist eine solche Ausführung in perspektivischer Ansicht dargestellt.

**Patentansprüche**

1. Drucktastenaggregat (1) für Empfangsgeräte der Nachrichtentechnik, insbesondere für Fernsehempfänger, mit einem Gehäuse (2, 3), mit sich gegenseitig auslösenden Drucktasten (4) zur Einschaltung einspeicherbarer, wahlweise einstellbarer elektrischer Werte von aus mehreren Spannungsteilern für Kapazitätsdiodenabstimmung bestehenden Kanalspeichern, mit den jeweiligen Drucktasten (4) zugeordneten, bedarfsweise mit einem Hilfsmittel drehbaren, in einer Vertiefung (8) verborgenen Drehknöpfe zur Kanalabstimmung und zur Auswahl des Frequenzbereiches, mit einer die Vertiefung (8) bedeckenden und zwei Raststellungen aufweisenden Klapptür (6), die zum Öffnen durch eine doppelseitige Drehverbindung im Gehäuse um eine Achse in einem Winkelbereich schwenkbar ist und die eine Zuhalteeinrichtung in Form eines starren Rastelementes aufweist, dadurch gekennzeichnet, daß die Drehverbindung aus mindestens einem an die Klapptür (6) angeformten drehaxialen Lagerzapfen (17), der mit einer Bohrung des Gehäuses (2, 3) als Drehlager zusammenwirkt, und/oder aus mindestens einem Federelement besteht, dessen vom Basisteil (26) der Klapptür (6) freigeschnittener Federarm (23) sich in drehaxialer Richtung erstreckt und das im Federarm (23) und/oder in dem Basisteil (26) der Klapptür (6) eine in der Profilierung einen halbkreisförmigen Abschnitt (36) aufweisende Aussparung (31) als Drehlager für einen an das Gehäuse (2, 3) angeformten Drehzapfen (25) aufweist, wobei ein weiterer Abschnitt (37) mit einer von einem Halbkreis abweichenden Profilierung vorgesehen ist und wobei das Federelement in im Drehzapfen vorgesehene Bereiche (33, 34) einrastet.

2. Drucktastenaggregat nach Anspruch 1, dadurch gekennzeichnet, daß Federarm (23) und Klapptür (6) im Bereich des Drehlagers an einer Einstecköffnung (27) je eine Anschrägung (29 bzw. 30) aufweisen.

3. Drucktastenaggregat nach einem der Ansprüche 1 oder 2, dadurch gekennzeichnet, daß die Aussparung (31) in dem Basisteil (26) der Klapptür (6) bezüglich ihrer Profilierung einen der Einstecköffnung (27) benachbarten kreissegmentförmigen ersten Abschnitt (36) und einen sich daran tangential anschließenden zweiten Abschnitt (37) in Form einer von der Einstecköffnung im Sinne einer Verengung der Aussparung einwärts gerichteten Schrägfläche aufweist.

4. Drucktastenaggregat nach einem der Ansprüche 1 bis 3, dadurch gekennzeichnet, daß der runde Drehzapfen (25) zwei Abflachungen (33 bzw. 34) besitzt, die am Umfang unter einem Winkel zueinander liegen, der dem Schwenkbereich der Klapptür (6) entspricht, wobei die erste Abflachung (33) mit dem Federarm (23) in der Schließstellung der Klapptür (6) und die zweite Abflachung (34) mit dem Federarm (23) in der geöffneten Stellung im Sinne einer Rastung zusammenwirken.

5. Drucktastenaggregat nach einem der Ansprüche 1 bis 4, dadurch gekennzeichnet, daß mehrere parallel liegende Vertiefungen vorhanden sind, die durch eine gemeinsame Klapptür (6) bedeckt sind, wobei in der Klapptür (6) mindestens ein Fenster für eine Drucktastenreihe ausgespart ist.

**Claims**

1. A push button unit (1) for receiving apparatus in the communications art, in particular for television receivers, comprising: a housing (2, 3); mutually releasable push buttons (4) for switching-on storable, optionally adjustable, electrical values from channel stores comprising a plurality of voltage dividers for capacitance diode adjustment; control knobs associated with respective ones of the push buttons (4), concealed in a recess (8) and rotatable as required with auxiliary means, for channel adjustment and for the selection of frequency range; a cover door (6) covering the recess (8) and having two stop positions, which door can be swivelled for opening about a double-sided rotary joint in the housing, round an axis through an angular range, and which has a holding device in the form of a rigid stop element; characterised in that the rotary joint comprises: at least one axially swivelling pivot pin (17) moulded onto the door (6), which pin co-operates with a bore of the housing (2, 3) as a rotary bearing; and/or at least one spring element, a spring arm (23) of which extends at a distance from the base part (26) of the door (6) in the rotary axial direction, there being in the spring arm (23) and/or base part (26) of the door (6) a recess (31) having a substantially semi-circular region (36) in profile to provide a rotary bearing for a pivot pin (25) moulded on the housing (2, 3), the recess (31) having a further region (37) provided with a profile different from a semi-circular one, and the spring element engaging on regions (33, 34) provided on the pivot pin.

2. A push button unit according to claim 1, characterised in that the spring arm (23) and the door (6), in the region of the rotary bearing, have a bevel (29 or 30) at an insertion aperture (27).

3. A push button unit according to one of claims 1 or 2, characterised in that the recess (31) has in the base part (26) of the door (6) a first region (36), adjacent to the insertion aperture (27), which is a substantially circular segment shape with regard to its profiling, and a second region (37) which is tangentially connected thereto and is in the form of a slanting surface which is inwardly directed from the insertion aperture like a kind of narrowing of the recess.

4. A push button unit according to any one of claims 1 to 3, characterised in that the round pivot pin (25) has two flat regions (33 and 34) which lie on the circumference at an angle to each other which corresponds to the pivotal range of the door (6), wherein the first flat area (33) co-operates with the spring arm (23) in the closed position of the door (6), and the second flat area (34) co-operates with the spring arm (23) in the open position like a kind of stop.

5. A push button unit according to any one of claims 1 to 4, characterised in that there is a plurality of parallel recesses which are covered by a common cover door (6), wherein in the door (6) there is cut out at least one window for a row of push buttons.

**Revendications**

1. Bloc (1) à boutons-poussoirs pour appareils récepteurs de télécommunication, notamment pour récepteurs de télévision, comportant un boîtier (2, 3), des boutons-poussoirs (4) qui se dégagent mutuellement, destinés à mettre en circuit les valeurs électriques mémorisables et réglables à volonté qui proviennent de mémoires de canaux composées de diviseurs de tension destinés à accorder des diodes capacitives, des boutons rotatifs qui coopèrent avec ces boutons-poussoirs et qui sont destinés à l'accord des canaux et au choix de la gamme de fréquences et qui sont cachés dans une cavité (8), et un volet rabattable (6) qui recouvre cette cavité (8), présente deux positions de retenue, peut pivoter d'un certain angle sur un axe dans le boîtier grâce à une jonction pivotante de chaque côté et comporte un dispositif de maintien en forme d'élément rigide cranté, bloc caractérisé en ce que la jonction pivotante est composée d'au moins un tourillon (17) qui est formé sur le volet (6) sur l'axe de pivotement et qui coopère avec un alésage du boîtier (2, 3) constituant un palier et/ou d'au moins un élément élastique, dont le bras élastique (23), découpé en partie dans la base (26) du volet (6), est orienté dans le sens de cet axe de pivotement et qui comporte dans ce bras élastique (23) et/ou dans la base (26) du volet (6) un évidement (31) présentant en profil un tronçon semi-circulaire (36) qui sert de palier à un pivot (25) formé sur le boîtier (2, 3) et un autre tronçon (37) à profil s'écartant du demi-cercle, l'élément élastique s'encliquetant sur une partie (33, 34) prévue à cet effet de ce pivot.

2. Bloc selon la revendication 1, caractérisé en ce que le bras élastique (23) et le volet (6) présentent chacun un chanfrein (29, 30) à hauteur d'une ouverture d'insertion (27) au niveau du pivot.

3. Bloc selon l'une des revendications 1 ou 2, caractérisé en ce que l'évidement (31) de la base (26) du volet (6) présente comme profil un premier tronçon (36) en segment de cercle, adjacent à l'ouverture d'insertion (27), et un second tronçon (37) qui s'y raccorde tangentiellement en formant une surface oblique partant de cette ouverture (27) vers l'intérieur et ayant pour effet de rétrécir cet évidement.

4. Bloc selon l'une des revendications 1 à 3, caractérisé en ce que le pivot rond (25) présente sur sa périphérie deux plats (33, 34) qui font entre eux un angle correspondant à l'amplitude du pivotement du volet (6), ces plats coopérant avec le bras élastique (23) en maintenant le volet, le premier (33) dans la position de fermeture de ce volet et le second (34) dans la position d'ouverture dudit volet.

5. Bloc selon l'une des revendications 1 à 4, caractérisé en ce qu'il comporte plusieurs cavités parallèles, qui sont recouvertes par un volet rabattable (6) commun, celui-ci comportant au moins une fenêtre pour les boutons-poussoirs d'une rangée.

**Fig. 1**

**Fig. 2**

**Fig. 3**

**Fig. 4**

**Fig. 5**

**Fig. 6**

**Fig. 7**

**Fig. 8**

**Fig. 9**